# EUROPEAN PATENT APPLICATION

(11) **EP 4 651 210 A1**
(43) Date of publication of application: **19.11.2025**
(21) Application number: 23916429.6
(22) Date of filing: 14.12.2023
(51) Int. Cl.: H01L 31/18, H01L 31/05

(54) **SOLAR BATTERY MANUFACTURING APPARATUS AND SOLAR BATTERY MANUFACTURING METHOD**

(30) Priority: 12.01.2023 KR 20230004920
(71) Applicant: Hanwha Solutions Corporation, Seoul 04541 (KR)
(72) Inventor: BAEK, Dong Heon, Seoul 04541 (KR); JUNG, Min Kyo, Seoul 04541 (KR)
(74) Representative: Mooser, Sebastian Thomas
(86) International application number: PCT/KR2023/020669
(87) International publication number: WO 2024/150946

(57) **Abstract**

A solar battery manufacturing apparatus according to an embodiment of the present invention comprises: a first dispenser for applying a conductive adhesive to first surfaces of solar battery cells; a flip part for flipping the solar battery cells; and a second dispenser for applying a conductive adhesive to second surfaces of the solar battery cells, wherein the flip part includes: a rotatable body part; and a first flip part coupled to one side part of the body part, and the first flip part includes: a first suction part for suctioning the solar battery cells in the direction in which the first flip part is positioned; and a first protrusion part having an end part protruding to come into contact with the solar battery cells.

## Description

### [Technical Field]

Embodiments of the present invention relate to a solar battery manufacturing apparatus and a solar battery manufacturing method.

### [Background Art]

A solar cell, that is, a solar battery, is formed by arranging diodes formed through a p-n junction on a substrate. When sunlight is radiated on solar batteries, excitons that are electron-hole pairs are generated, and as the excitons are separated, electrons move to an n layer, and holes move to a p layer so that photovoltaic power is generated at a p-n junction. Tabbing is a process of forming a single solar cell module by arranging wires on a plurality of solar batteries to electrically connect the plurality of solar batteries.

In this case, as a process of coupling solar batteries and wires, there is a process of coating surfaces of solar batteries with an electrically conductive adhesive (ECA) and then coupling the wires to the solar batteries.

In the case of a process of coupling solar cells and wires using conductive adhesives, a variety of research is being conducted on specific examples of next-generation solar battery manufacturing processes.

### [Detailed Description of Invention]

### [Technical Problem]

The object to be solved by the present invention is to provide a solar battery manufacturing apparatus and a solar battery manufacturing method including a process of coupling a solar cell and a wire using a conductive adhesive.

However, the objects are exemplary, and the objects to be solved by the present invention are not limited thereto.

### [Technical Solution]

A solar battery manufacturing apparatus according to one embodiment of the present invention includes a first dispenser configured to coat a first surface of a solar cell with a conductive adhesive, a flip portion configured to flip the solar cell, and a second dispenser configured to coat a second surface of the solar cell with a conductive adhesive, wherein the flip portion includes a main body which rotates, and a first flip portion coupled to one side of the main body, and the first flip portion includes a first adsorption portion configured to adsorb the solar cell in a direction in which the first flip portion is positioned, and a first protrusion formed such that an end portion thereof protrudes to come into contact with the solar cell.

The solar battery manufacturing apparatus may further include a first conveyor configured to transfer the solar cell, of which the first surface is coated through the first dispenser, to a position at which the flip portion is positioned, and a second conveyor configured to transfer the solar cell flipped through the flip portion to a position at which the second dispenser is positioned.

The first flip portion may be coupled to the second surface of the solar cell through the first protrusion and the first adsorption portion, and when the main body rotates, the first flip portion may be uncoupled from the solar cell and seats the solar cell on the second conveyor.

The second conveyor may further include a protruding conveyor formed to protrude from a surface of the second conveyor, and a width of the protruding conveyor may be smaller than a width of the second conveyor.

An upper surface of the first conveyor and an upper surface of the protruding conveyor may be positioned on a horizontal line (L).

The solar battery manufacturing apparatus may further include a heat treatment zone configured to allow the solar cell passing the second dispenser to be coupled to a wire.

The first protrusion may be formed as a plurality of first protrusions that come into contact with a plurality of portions of the solar cell.

The first protrusion are formed as four protrusions, and the four protrusions may be symmetrically disposed at four positions centered on the first adsorption portion.

An end portion of the first protrusion may be formed as a new member.

The first dispenser may apply the conductive adhesive on the first surface of the solar cell positioned below the first dispenser, and the second dispenser may apply the conductive adhesive on the second surface of the solar cell positioned below the second dispenser.

The first flip portion may be formed as one or more first flip portions.

The first flip portions may be formed at both sides with respect to the main body, and as the main body rotates, two first flip portions may alternately flip the solar cell.

A solar battery manufacturing method according to one embodiment of the present invention includes transferring a solar cell to a position at which a first dispenser is positioned, coating a first surface of a solar cell with a conductive adhesive through the first dispenser, transferring the solar cell, of which the first surface is coated with the conductive adhesive, to a flip portion through a first conveyor, flipping, by the flip portion, the solar cell, transferring the flipped solar cell to a position at which a second dispenser is positioned, and coating, by the second dispenser, a second surface of the solar cell with a conductive adhesive.

The flipping, by the flip portion, of the solar cell may include coupling a first flip portion to the second surface of the solar cell through a first protrusion and a first adsorption portion of the first flip portion, rotating a main body of the first flip portion, and uncoupling the first flip portion from the solar cell, and seating the solar cell on a second conveyor in a state of being flipped.

The solar battery manufacturing method may further include moving the solar cell, of which both the first and second surfaces are coated with the conductive adhesives, to a heat treatment zone, and performing a wire coupling process.

Other aspects, features, and advantages other than those described above will become apparent from the following detailed description, claims and drawings for embodying the present invention.

### [Advantageous Effects]

In a solar battery manufacturing apparatus and a solar battery manufacturing method according to one embodiment of the present invention, both a front surface and a rear surface of a solar cell can be coated through a dispenser and a flip portion that flips the solar cell.

In addition, in a solar battery manufacturing apparatus and a solar battery manufacturing method according to one embodiment of the present invention, both first and second dispensers can coat a solar cell from top to bottom without having to coat the solar above and below to coat both surfaces of the solar cell so that, when both surfaces of the solar cell are coated, the conditions of two dispensers can be set to be the same. Thus, an application device can be simplified, and two dispensers can be formed with the same specifications to be interchanged with each other, thereby improving convenience.

In addition, in a solar battery manufacturing apparatus and a solar battery manufacturing method according to one embodiment of the present invention, when a second surface of a solar cell is coated, a narrow protruding conveyor is additionally provided to minimize contact with a conductive adhesive already applied on a first surface.

In addition, in a solar battery manufacturing apparatus and solar battery manufacturing method according to one embodiment of the present invention, a new member is applied as an end member of a protrusion in contact with a surface of a solar cell, thereby protecting the surface of the solar cell and preventing a material from being torn or peeled off of the surface of the solar cell.

In addition, in a solar battery manufacturing apparatus and a solar battery manufacturing method according to one embodiment of the present invention, by newly forming a heat treatment zone for coupling a wire and a coated solar cell after the coating of a front surface and a rear surface of the solar cell is completed, a total available cycle (TAC) time can be shortened.

The effects of the present invention are not limited to those described above, and other effects that have not been described will be clearly understood by those of ordinary skill in the art based on the description of the claims.

### [Description of Drawings]

FIG. 1 is a top view of a solar battery manufacturing apparatus according to one embodiment of the present invention.
FIG. 2 is a side view of the solar battery manufacturing apparatus according to one embodiment of the present invention.
FIG. 3 is a side view illustrating a configuration around a flip portion of the solar battery manufacturing apparatus according to one embodiment of the present invention in more detail.
FIG. 4 is a view illustrating a configuration of a first adsorption portion and a first protrusion of a first flip portion according to one embodiment of the present invention.
FIG. 5 is a top view illustrating the flip portion and a configuration therearound according to one embodiment of the present invention in more detail.
FIG. 6 is a side view illustrating a configuration around the flip portion of the solar battery manufacturing apparatus including a conveyor in FIG. 3 in more detail.
FIG. 7 is a flowchart showing a solar battery manufacturing method according to one embodiment of the present invention.

### [Modes of the Invention]

Since various transformations can be applied to the present invention which has various embodiments, specific embodiments will be illustrated in the drawings and described in detail in the detailed description. However, it should be understood that this is not intended to limit the present invention to specific embodiments, which includes all transformations, equivalents, and substitutes included in the spirit and scope of the present invention. In the description of the present invention, even when illustrated in different embodiments, like reference numerals refer to like components.

Hereinafter, embodiments of the present invention will be described in detail with reference to the accompanying drawings, wherein like reference numerals refer to the same or corresponding components throughout the drawings, and redundant description thereof will be omitted.

In the following embodiments, the terms "first," "second," and the like do not have limiting meanings but are used for the purpose of distinguishing one component from another component.

In the following embodiments, the expressions used in the singular such as "a" and "an" are intended to include the plural forms as well, unless the context clearly indicates otherwise.

In the following embodiments, it will be understood that terms such as "including," "comprising," and "having" specify the presence of stated features or components, but do not preclude the presence or addition of one or more other features or components.

In the drawings, components may be exaggerated or reduced in size for convenience of description. For example, the sizes and thicknesses of the respective components shown in the drawings are arbitrarily shown for convenience of description, and thus one or more embodiments are not necessarily limited thereto.

When a certain embodiment may be implemented differently, a specific process order may be performed differently from the described order. For example, two consecutively described processes may be performed substantially at the same time or may be performed in an order opposite to the described order.

The terms used herein are merely used to describe specific embodiments and are not intended to limit the present invention. In the present application, the word "comprise" or "have" is used to specify the presence of a feature, number, process, operation, constituent element, part, or combination thereof, and it will be understood that the presence or additional possibility of one or more other features or numbers, processes, operations, constituent elements, parts, or combinations thereof is not excluded in advance.

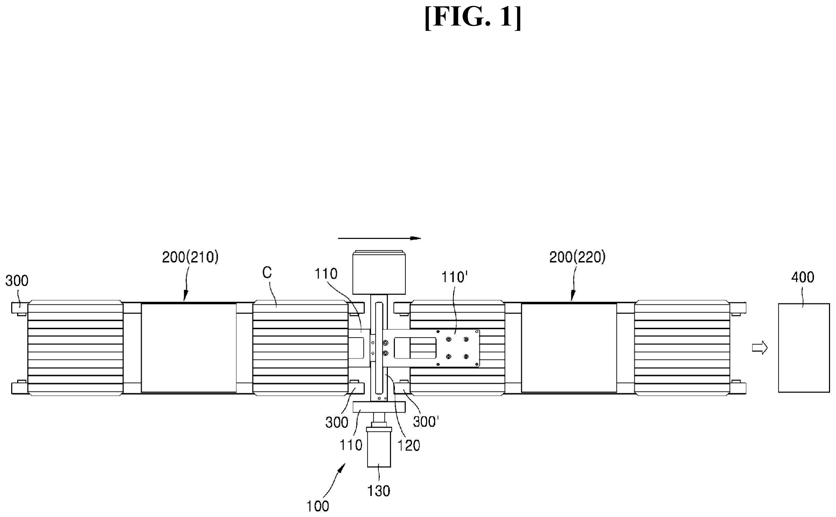

Hereinafter, a solar battery manufacturing apparatus according to one embodiment of the present invention will be described with reference to FIGS. 1 to 6.

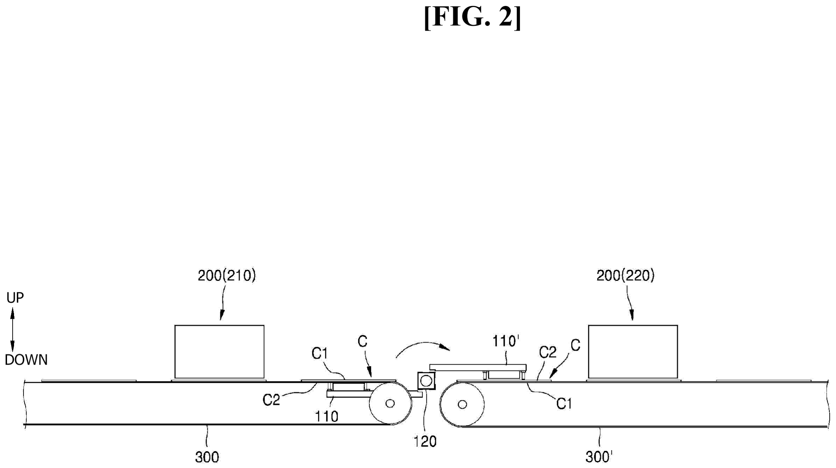

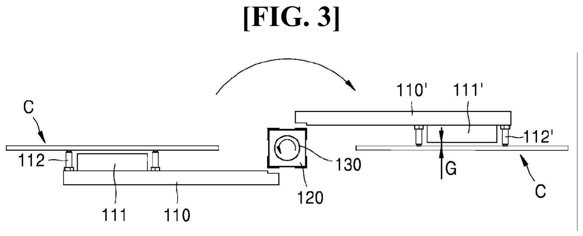

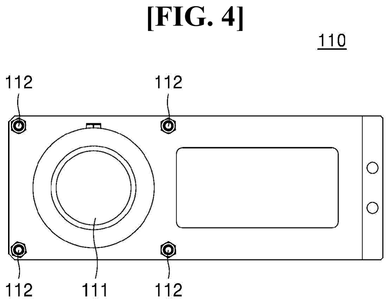

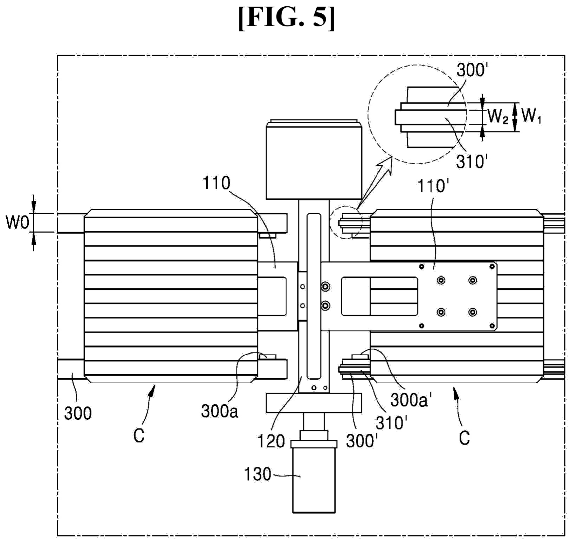

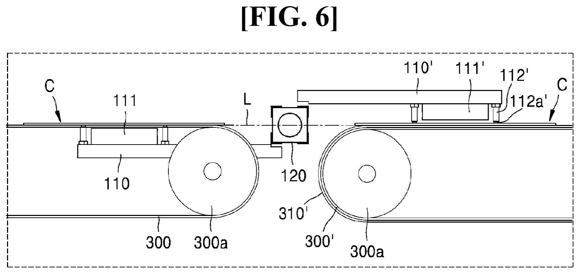

FIG. 1 is a top view of the solar battery manufacturing apparatus according to one embodiment of the present invention. FIG. 2 is a side view of the solar battery manufacturing apparatus according to one embodiment of the present invention. FIG. 3 is a side view illustrating a configuration around a flip portion of the solar battery manufacturing apparatus according to one embodiment of the present invention in more detail. FIG. 4 is a view illustrating a configuration of a first adsorption portion and a first protrusion of the first flip portion according to one embodiment of the present invention. FIG. 5 is a top view illustrating the flip portion and a configuration therearound according to one embodiment of the present invention in more detail. FIG. 6 is a side view illustrating a configuration around the flip portion of the solar battery manufacturing apparatus including a conveyor in FIG. 3 in more detail.

Referring to FIGS. 1 to 6, the solar battery manufacturing apparatus according to one embodiment of the present invention includes a first dispenser 210 for applying a conductive adhesive on a first surface C1 of a solar cell C, a flip portion 100 for flipping the solar cell C, and a second dispenser 220 for applying a conductive adhesive to a second surface C2 of the solar cell C. In this case, the flip portion 100 includes a rotating main body 120 and a first flip portion 110 coupled to one side of the main body 120, and the first flip portion 110 includes a first protrusion 112 formed such that an end portion 112a protrudes to come into contact with the solar cell, and a first adsorption portion 111 that adsorbs the solar cell C in a direction in which the flip portion is positioned.

The solar cell C may be transferred to a position at which the first dispenser 210 is positioned, specifically, to a space below the first dispenser 210, through a first conveyor 300. In this case, the transferred solar cell C may be in a state in which the first surface C1 faces upward. In the solar cell C transferred to the space below the first dispenser 210 through the first conveyor 300, a conductive adhesive may be applied on the first surface C1 by the first dispenser 210. In this case, the first dispenser 210 may perform a coating process on the solar cell C positioned in the space below the first dispenser 2190 in the direction of gravity.

The solar cell C of which the first surface C1 has been completely coated may be transferred back to a position at which the flip portion 100 is positioned through the first conveyor 300. In this case, the first flip portion 110 of the flip portion 100 may be disposed in a space below the solar cell C. In the first flip portion 110, in the space below the solar cell C, the first adsorption portion 111 and the first protrusion 112 may be formed to protrude toward the second surface C2 of the solar cell C.

The first adsorption portion 111 may adsorb the solar cell C in a direction in which the first flip portion 110 is positioned. The first adsorption portion 111 may be spaced apart from the solar cell C. In addition, the first protrusion 112 may be formed such that the end portion 112a protrudes to come into contact with the solar cell. Thus, when the first adsorption portion 111 adsorbs the second surface C2 of the solar cell C, the second surface C2 of the solar cell C may be spaced apart from the first adsorption portion 111 and may come into contact with the first protrusion 112. Accordingly, a contact area between the flip portion 100 and the solar cell C can be minimized, and the first protrusion 112 and the second surface C2 of the solar cell C can be brought into contact with each other by a suction force of the first adsorption portion 111 to maintain a mutually coupled state.

As an example, the first adsorption portion 111 may absorb the solar cell C in a non-contact state by using the Bernoulli effect. Specifically, the flip portion 100 may discharge compressed air to an edge area of the first adsorption portion 111 to form a vacuum between the first adsorption portion 111 and the second surface C2 of the solar cell C and may absorb the solar cell C in a non-contact manner by using negative pressure due to a pressure difference. To this end, the first adsorption portion 111 may include a flow unit (not shown) that provides compressed air toward the solar cell C, and a guide portion (not shown) that discharges the compressed air toward an edge area of a lower surface of the first adsorption portion 111 facing the solar cell C at an end portion of the flow portion.

After the first flip portion 110 and the solar cell C are coupled to each other, the flip portion 100 may rotate. In this case, the first flip portion 110 may be rotated around the main body 120 of the flip portion 100 together with the adsorbed and coupled solar cell C. The rotation may be performed at an angle of 180 degrees.

After the rotation of the flip portion 100 is completed, the solar cell C may be positioned below a first flip portion 110'. In this case, an upper surface of the solar cell C may become the second surface C2, and a lower surface of the solar cell C may become the first surface C1.

After the rotation of the flip portion 100 is completed, the first flip portion 110' may be uncoupled from the solar cell C. In this case, when the operation of the first adsorption portion 111' is stopped, contact coupling between a first protrusion 112' and the solar cell C may be spontaneously released.

At the same time, the solar cell C may be seated on a second conveyor 300'. According to the present embodiment, the second conveyor 300' may have a set width W₁. For example, the width W₁ of the second conveyor 300' may be smaller than or equal to a width W0 of the first conveyor 300. Accordingly, damage to a conductive adhesive applied on one surface of the solar cell C from the second conveyor 300' can be prevented and/or minimized. In addition, the second conveyor 300' may include a protruding conveyor 310' that is formed to protrude from a surface of the second conveyor 300'. In this case, a width W₂ of the protruding conveyor 310' may be smaller than the width W₁ of the second conveyor 300'. For example, the width of the protruding conveyor 310' may be formed to be considerably narrow to form an approximately linear shape.

The protruding conveyor 310' may come into contact with a surface of the solar cell C between conductive adhesive-applied portions of the surface of the solar cell C. Thus, the protruding conveyor 310' may support both sides of the solar cell C and may simultaneously transfer the solar cell C safely to a position at which the second dispenser 220 is positioned.

In the solar cell C flipped through the flip portion 100, the first surface C1 faces downward while being coated with a conductive adhesive. In this case, the first surface C1 inevitably comes into contact with a surface of the second conveyor 300'. Accordingly, as in the present embodiment, a contact area between the protruding conveyor 310' and the first surface C1 on which a conductive adhesive is applied is minimized through a structure of the protruding conveyor 310' additionally formed on the second conveyor 300', thereby minimizing damage to the surface of the solar cell on which the conductive adhesive is applied.

In this case, according to the present embodiment, as shown in FIG. 6, the first conveyor 300 and the second conveyor 300' may be disposed at different levels. For example, an upper surface of the first conveyor 300 may be positioned at a higher level and closer to the solar cell C than an upper surface of the second conveyor 300'. In addition, the upper surface of the first conveyor 300 and the upper surface of the protruding conveyor 310' may be positioned on a horizontal line L. In a process of transferring the solar cell C from the first conveyor 300 to the second conveyor 300', by constantly maintaining a height at which the solar cell C is disposed, a dispensing process of each of the first and second dispensers 210 and 220 may be set under the same conditions. Accordingly, two dispenser processes can be performed under the same structure and conditions so that a manufacturing process of a dispenser device can be simplified, interchangeability between dispenser devices can be achieved, and uniformity in the quality of a dispenser process can also be secured.

In addition, since the first dispenser 210 applies a conductive adhesive on the first surface C1 of the solar cell C positioned below the first dispenser 210, and the second dispenser 220 applies a conductive adhesive on the second surface C2 of the solar cell C positioned below the second dispenser 220, a dispensing structure does not need to be disposed in the space below the solar cell C in order to coat both surfaces of the solar cell C with a conductive adhesive, and thus the two dispensers 210 and 220 can apply a conductive adhesive on both surfaces of the solar cell C under the same conditions.

The protruding conveyor 310' of the second conveyor 300' may transfer the solar cell C to the position at which the second dispenser 220 is positioned, specifically, to a space below the second dispenser 220. In this case, the transferred solar cell C may be in a state in which the second surface C2 faces upward. In the solar cell C transferred to the space below the second dispenser 220 through the protruding conveyor 300', a conductive adhesive may be applied on the second surface C2 by the second dispenser 220. In this case, the second dispenser 220 may perform a coating process on the solar cell C positioned in the space below the second dispenser 220 in the direction of gravity.

According to the present embodiment, the solar cell C that has passed the second dispenser 220 may be transferred to a heat treatment zone 400 for allowing the solar cell C to be coupled to a wire. The heat treatment zone 400 may dry an applied electrically conductive adhesive (ECA) at a temperature of 50 degrees to 250 degrees to maximize adhesion. In the heat treatment zone 400, a process in which the solar cell C coated with a conductive adhesive, and the wire are cured and coupled through heat treatment may be performed. In this way, by newly forming the heat treatment zone 400 for curing and coupling with the wire formed in the solar cell on which a conductive adhesive is applied, a total available cycle (TAC) time according to wire coupling can be shortened.

According to the present embodiment, a plurality of first protrusions 112 may be formed to come into contact with a plurality of portions of the solar cell C. For example, as shown in FIG. 4, four first protrusions 112 may be formed and may be symmetrically disposed at four positions centered on the first adsorption portion 111.

Since the first adsorption portion 111 is positioned at a center forming a symmetrical point of the four first protrusions 112, the solar cell C may come into uniform contact with and be coupled to the four first protrusions 112 when the first adsorption portion 111 operates for adsorption.

In this case, the first adsorption portion 111 may be formed to have a predetermined gap G with the solar cell C, and the first protrusion 112 may be formed to further protrude from a surface of the first flip portion 110 than the first adsorption portion 111. The first adsorption portion 111 may suction air through the gap G.

In addition, since the first protrusions 112 symmetrically come into contact with the surface of the solar cell C, the solar cell C may come into uniform contact with and be coupled to the four first protrusions 112 without being biased to one side. In the present embodiment, the four first protrusions 112 are formed, but the number and arrangement positions of the first protrusions 112 are not limited thereto. Various embodiments can be implemented as long as the number and arrangement positions of the first protrusions 112 capable of stably flipping the solar cell are provided.

According to the present embodiment, the end portion 112a of the first protrusion 112 may be made of a material that has a predetermined frictional force and does not damage the solar cell C when in contact with the solar cell C. For example, the end portion 112a may include a resin material such as a urethane resin. Accordingly, when the end portion 112a comes into contact with the surface of the solar cell C, peeling or tearing of a surface material of the solar cell C (for example, tearing of a perovskite) can be prevented, thereby improving a defect rate. In addition, the end portion 112a may have a predetermined frictional force with the solar cell C so that, when the solar cell C is transferred, the solar cell C may be transferred to a set position.

According to the present embodiment, one or more first flip portions 110 may be formed. For example, the first flip portions 110 may be formed at a 180-degree angle at both sides with respect to the main body 120, and as the main body 120 rotates, the two first flip portions 110 may alternately flip the solar cell C.

In this way, a coating process of the solar cell C may be performed more densely through a structure in which the two first flip portions 100 are disposed, thereby improving productivity.

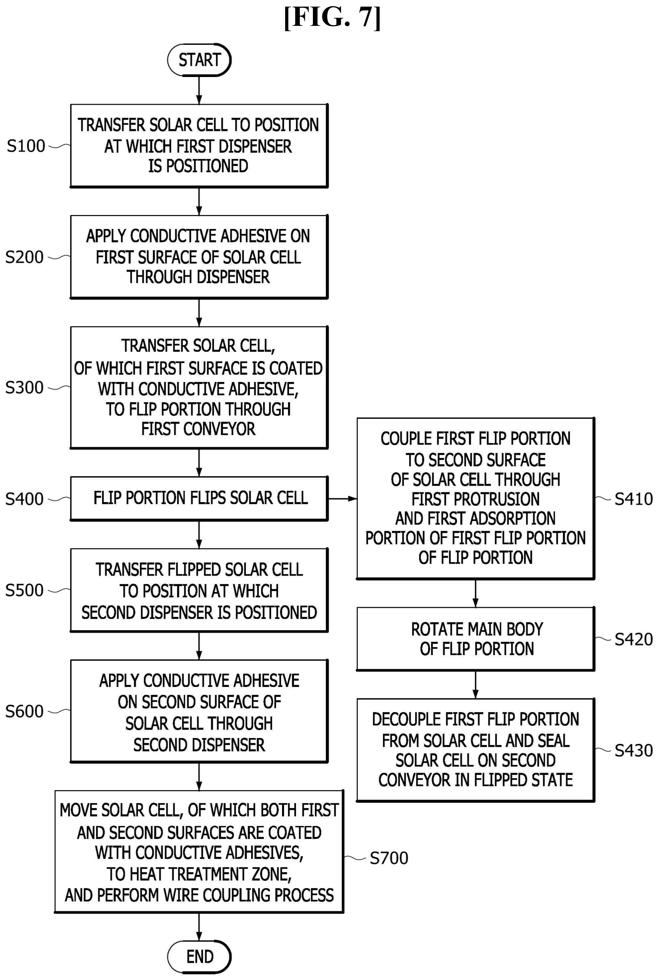

Hereinafter, with reference to FIG. 7, a solar battery manufacturing method according to one embodiment of the present invention will be described. For details not shown in FIG. 7, FIGS. 1 to 6 may be referred to.

FIG. 7 is a flowchart illustrating a solar battery manufacturing method according to one embodiment of the present invention.

Referring to FIG. 7, the solar battery manufacturing method according to one embodiment of the present invention includes operation S100 of transferring a solar cell to a position at which a first dispenser is positioned, operation S200 of coating a first surface of the solar cell with a conductive adhesive through a first dispenser, operation S300 of transferring the solar cell, of which the first surface is coated with the conductive adhesive, to a flip portion through a first conveyor, operation S400 of flipping, by the flip portion, the solar cell, operation S500 of transferring the flipped solar cell to a position at which a second dispenser is positioned, and operation S600 of coating, by a second dispenser, a second surface of the solar cell with the conductive adhesive.

In this case, the solar battery manufacturing method may further include operation S700 of moving the solar cell, of which both the first and second surfaces are coated with the conductive adhesives, to a heat treatment zone, and performing a wire coupling process.

In addition, operation S400 of flipping, by the flip portion, the solar cell may include operation S410 of coupling a first flip portion to the second surface of the solar cell through a first protrusion and a first adsorption portion of the first flip portion of the flip portion, operation S420 of rotating a main body of the flip portion, and operation S430 of decoupling the first flip portion from the solar cell and seating the solar cell on a second conveyor in a flipped state.

Thus, it is possible to secure uniformity of quality in a process of coating a solar cell with a conductive adhesive, shorten a TAC time through optimization, and secure productivity.

The present invention has been described above with reference to the embodiment shown in the drawings, but this is only an example. Those of ordinary skill in the art may fully understand that various modifications and other equivalent embodiments are possible from the embodiments. Therefore, the true technical protection scope of the present invention should be determined based on the appended claims.

Specific technical content described in the embodiment is an embodiment and does not limit the technical scope of the embodiment. In order to concisely and clearly describe the invention, descriptions of conventional general techniques and configurations may be omitted. In addition, the connection or connection members of lines between the components shown in the drawings are illustrative of functional connections and/or physical or circuit connections and may be represented as a variety of functional connections, physical connections, or circuit connections that are replaceable or additional in an actual device. In addition, anything for which there is no specific mention such as "essential" or "importantly" may not be an essential component for the application of the present invention.

In the description of the invention and in the claims, "the" or similar referents may refer to both the singular and the plural unless otherwise specified. In addition, when a range is described in the embodiment, it includes the invention to which individual values within the range are applied (unless there is a description to the contrary), and each individual value constituting the range is described in the description of the invention. In addition, the operations constituting the method according to the embodiment may be performed in an appropriate order unless the order is explicitly stated or there is description to the contrary. The embodiments are not necessarily limited by the described order of the operations. The use of all examples or illustrative terms (e.g., "and the like") in the embodiment is merely for the purpose of describing the embodiment in detail, and unless limited by the claims, the scope of the embodiments is not limited by the above examples or exemplary terms. In addition, those skilled in the art will appreciate that various modifications, combinations, and changes may be made in accordance with design conditions and factors within the scope of the appended claims or their equivalents.

## Claims

1. A solar battery manufacturing apparatus comprising:
a first dispenser configured to coat a first surface of a solar cell with a conductive adhesive;
a flip portion configured to flip the solar cell; and
a second dispenser configured to coat a second surface of the solar cell with a conductive adhesive,
wherein the flip portion includes
a main body which rotates; and
a first flip portion coupled to one side of the main body, and
wherein the first flip portion includes
a first adsorption portion configured to adsorb the solar cell in a direction in which the first flip portion is positioned, and
a first protrusion formed such that an end portion thereof protrudes to come into contact with the solar cell.

2. The solar battery manufacturing apparatus of claim 1, further comprising:
a first conveyor configured to transfer the solar cell, of which the first surface is coated through the first dispenser, to a position at which the flip portion is positioned; and
a second conveyor configured to transfer the solar cell flipped through the flip portion to a position at which the second dispenser is positioned.

3. The solar battery manufacturing apparatus of claim 2, wherein the first flip portion is coupled to the second surface of the solar cell through the first protrusion and the first adsorption portion, and
when the main body rotates, the first flip portion is uncoupled from the solar cell and seats the solar cell on the second conveyor.

4. The solar battery manufacturing apparatus of claim 2, wherein the second conveyor further includes a protruding conveyor formed to protrude from a surface of the second conveyor, and
a width of the protruding conveyor is smaller than a width of the second conveyor.

5. The solar battery manufacturing apparatus of claim 4, wherein an upper surface of the first conveyor and an upper surface of the protruding conveyor are positioned on a horizontal line (L).

6. The solar battery manufacturing apparatus of claim 1, further comprising a heat treatment zone configured to allow the solar cell passing the second dispenser to be coupled to a wire.

7. The solar battery manufacturing apparatus of claim 1, wherein the first adsorption portion is spaced apart from the solar cell, and
the first protrusion is formed as a plurality of first protrusions that come into contact with a plurality of portions of the solar cell.

8. The solar battery manufacturing apparatus of claim 2, wherein a width of the second conveyor is smaller than or equal to a width of the first conveyor.

9. The solar battery manufacturing apparatus of claim 1, wherein the first dispenser applies the conductive adhesive on the first surface of the solar cell positioned below the first dispenser, and
the second dispenser applies the conductive adhesive on the second surface of the solar cell positioned below the second dispenser.

10. The solar battery manufacturing apparatus of claim 1, wherein the first flip portion is formed as one or more first flip portions.

11. The solar battery manufacturing apparatus of claim 10, wherein the first flip portions are formed at both sides with respect to the main body, and
as the main body rotates, two first flip portions alternately flip the solar cell.

12. A solar battery manufacturing method comprising:
transferring a solar cell to a position at which a first dispenser is positioned;
coating a first surface of a solar cell with a conductive adhesive through the first dispenser;
transferring the solar cell, of which the first surface is coated with the conductive adhesive, to a flip portion through a first conveyor;
flipping, by the flip portion, the solar cell;
transferring the flipped solar cell to a position at which a second dispenser is positioned; and
coating, by the second dispenser, a second surface of the solar cell with a conductive adhesive.

13. The solar battery manufacturing method of claim 12, wherein the flipping, by the flip portion, of the solar cell includes;
coupling a first flip portion to the second surface of the solar cell through a first protrusion and a first adsorption portion of the first flip portion;
rotating a main body of the first flip portion; and
uncoupling the first flip portion from the solar cell and seating the solar cell on a second conveyor in a state of being flipped.

14. The solar battery manufacturing method of claim 12, further comprising moving the solar cell, of which both the first and second surfaces are coated with the conductive adhesives, to a heat treatment zone, and performing a wire coupling process.
